# EUROPÄISCHE PATENTSCHRIFT

(11) **EP 0 438 616 B1**
(45) Veröffentlichungstag und Bekanntmachung des Hinweises auf die Patenterteilung: **20.04.1994**
(21) Anmeldenummer: 90101335.9
(22) Anmeldetag: 23.01.1990
(51) Int. Cl.: G01R 15/02, H01F 40/06

(54) **Strom-Spannungswandler für elektronische Haushaltszähler**
Current-voltage transformer for domestic electronic power meters
Transformateur courant-tension pour des compteurs domestiques électroniques

(43) Veröffentlichungstag der Anmeldung: 31.07.1991
(73) Patentinhaber: SIEMENS AKTIENGESELLSCHAFT, 80333 München (DE)
(72) Erfinder: Schwendtner, Manfred, Dipl.-Ing., D-8501 Schwarzenbruck (DE); Dohmstreich, Wolfgang, Dipl.-Ing. (FH), D-8560 Lauf (DE); Steinmüller, Günter, Dipl.-Ing. (FH), D-8500 Nürnberg (DE)

(56) Entgegenhaltungen:
- EP-A- 0 243 630
- FR-A- 2 312 844

## Beschreibung

Die Erfindung betrifft einen Strom-Spannungswandler für elektronische Haushaltszähler, dessen Primärwindung über einen ferromagnetischen Kern mit einer Meßspule magnetisch gekoppelt ist.

Elektronische Haushaltszähler der vorgenannten Art benötigen zur Ermittlung des Energieverbrauches Meßwertumformer, die den Verbraucherstrom in elektrische Größen umwandeln, die von elektronischen Komponenten weiterverarbeitet werden können. Dazu ist es erforderlich, Verbraucherströme von z.B. 100 A in Meßströme oder Meßspannungen im mA- oder mV-Bereich umzuwandeln. Darüber hinaus besteht bei Drehstromzählern das Erfordernis, daß die Wandler eine sichere Potentialtrennung gewährleisten müssen. Eine weitere Forderung ist die Unempfindlichkeit gegen äußere magnetische Störfelder und die Unabhängigkeit der Umwandlung von einer eventuellen Gleichstromvormagnetisierung.

Insbesondere zur Vermeidung des Einflusses von äußeren magnetischen Störfeldern auf das Umwandlungsergebnis ist aus der DE-PS 36 19 423 eine Stromwandleranordnung bekannt, bei der der Primärleiter als gefalteter Flachleiter mit gegenüberliegenden Leiterabschnitten ausgebildet ist, der mit zwei schleifenförmigen Ausnehmungen versehen ist, die je eine Stromschleife bilden. Jeder Stromschleife ist eine mit 50% der insgesamt vorhandenen Windungen versehene gegensinnig gewickelte Meßspule zugeordnet. Beide Meßspulen sind zwischen den beiden hin- und rückleitenden Flachleitern angeordnet, die aus magnetisch abschirmendem Material bestehen. Auf diese Weise soll erreicht werden, daß die Meßspulen weitgehend von magnetischen Fremdfeldern abgeschirmt sind und die Restwirkung durch die gegensinnige Wicklung der beiden Meßspulen kompensiert wird. Diese Anordnung ist verhältnismäßig aufwendig und raumgreifend und liefert außerdem wegen der geringen Kopplung durch den fehlenden Kern aus ferromagnetischem Material zwischen Primärwindung und Sekundärspulen nur sehr geringe Ausgangssignale.

Der Erfindung liegt die Aufgabe zugrunde, einen Strom-Spannungswandler zu schaffen, der kompakt ist, ein hohes Ausgangssignal liefert und dennoch frei ist vom Einfluß äußerer magnetischer Störfelder und bei dem sich eine Gleichstromvormagnetisierung nur innerhalb der zulässigen Toleranzgrenzen auswirkt.

Diese Aufgabe wird durch die im Patentanspruch 1 angegebene Erfindung gelöst. Dadurch ist erreicht, daß äußere magnetische Störfelder über den Kern aus ferromagnetischem Material gebündelt um den Luftspalt und damit die Meßspule herumgeführt werden. Der Kern fungiert gleichzeitig als magnetische Abschirmung gegenüber der Meßspule. Außerdem wird durch den Luftspalt die Gleichstromvormagnetisierung klein gehalten und bewegt sich im Bereich des Zulässigen. Dies gilt auch für die effektive Permeabilität, deren Temperaturabhängigkeit durch den Luftspalt ebenfalls so weit reduziert wird, daß sie vernachlässigbar ist.

Durch die im Patentanspruch 2 angegebene Ferritkernaus führung des ferromagnetischen Kerns ist eine besonders gute und reproduzierbare mechanische Stabilität des Luftspaltes erreicht, da der Magnetkreis aus einem kompakten Teil besteht.

Die beanspruchte Formgebung des Kernes nach Patentanspruch 3 ist in festigungstechnischer Hinsicht besonders vorteilhaft.

Gemäß Patentanspruch 4 wird der Spulenkörper der Meßspule gleichzeitig als Halterungselement benutzt mit dem Vorteil, daß eine präzise Einfügung der Meßspule in den Luftspalt auch in der Massenproduktion ohne wesentlichen Justierungsaufwand möglich ist.

Anhand eines Ausführungsbeispieles wird die Erfindung im folgenden näher erläutert. Darin zeigen:
- Fig. 1: den Wandler in Seitenansicht,
- Fig. 2: einen Querschnitt durch die im Luftspalt angeordnete Meßspule des Wandlers,
- Fig. 3: eine Fehlerkurve,
- Fig. 4 und 5: eine Prinzipdarstellung des Feldlinienverlaufes von auf den Wandler einwirkenden äußeren magnetischen Störfeldern, und
- Fig. 6 und 7: die Meßspule mit Halterungskörper.

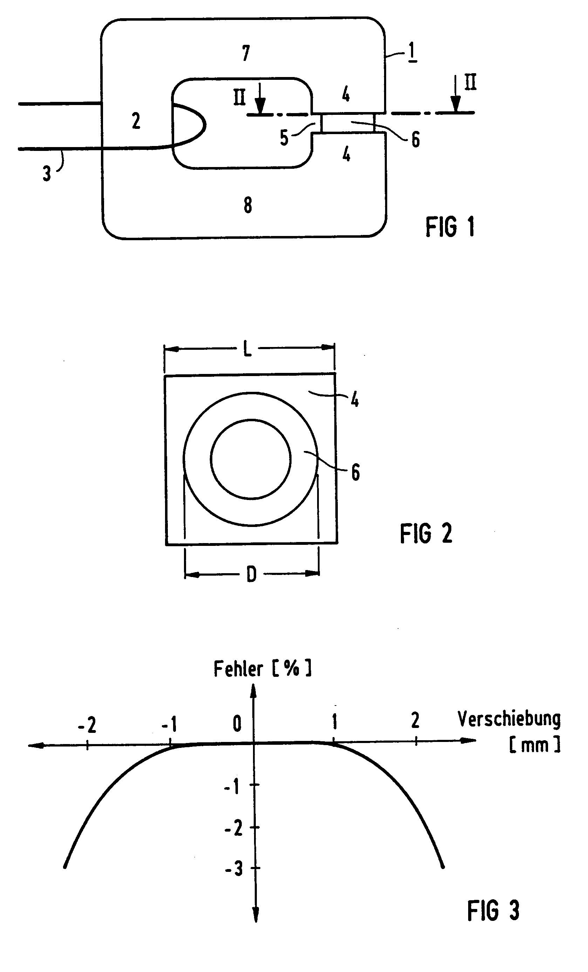

Der in Fig. 1 dargestellte Wandler besteht aus einem U-förmigen Kern 1 aus keramischem ferromagnetischem Material (Ferritkern), dessen Primärjoch 2 die Primärwindung 3 trägt und dessen Sekundärjoch 4 durch einen Luftspalt 5 unterbrochen ist. Im Luftspalt ist eine Meßspule 6 angeordnet.

In Fig. 2 ist der Luftspalt 5 mit eingefügter Meßspule 6 im Querschnitt dargestellt. Daraus ist ersichtlich, daß der Außendurchmesser D der Meßspule 6 kleiner ist als die Kantenlänge L des quadratischen Kernquerschnittes im Luftspalt, die Meßspule also derart bemessen ist, daß sie innerhalb der Querschnittsfläche des Kernes liegt, diese also an keiner Stelle außen überragt.

Aus dem in Fig. 3 gezeigten, zur Querschnittsdarstellung der Fig. 2 maßstabsgerechten Fehlerdiagramm ist der prozentuale Meßfehler in Abhängigkeit von der Verschiebung der Meßspule 6 im Luftspalt zu entnehmen. Daraus ist zu erkennen, daß der Meßfehler erst dann deutlich ansteigt, wenn die Meßspule 6 beginnt, das homogene Magnetfeld des Kernes zu verlassen.

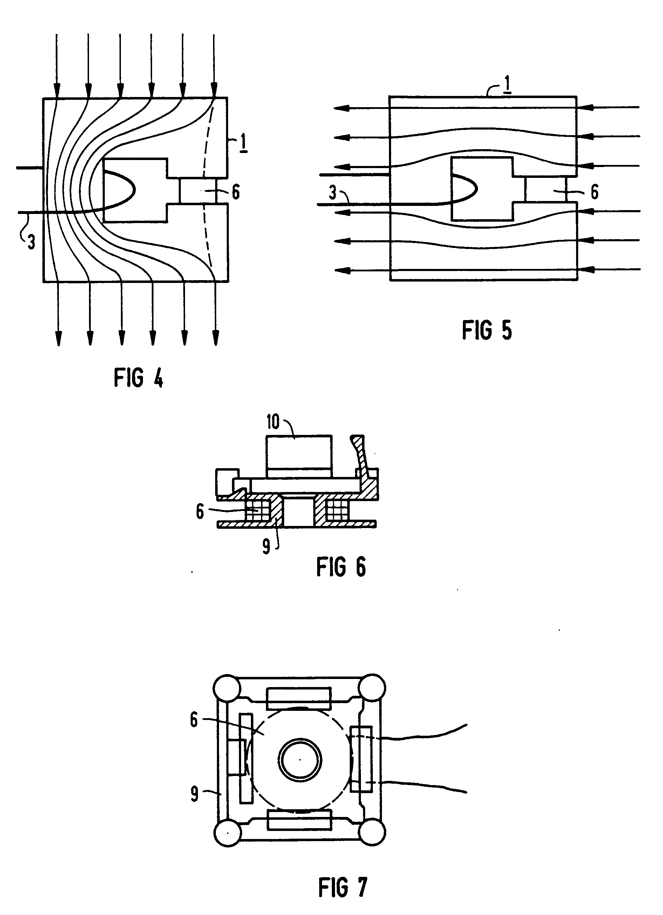

In Fig. 4 ist der Feldlinienverlauf eines in Richtung der Zentralachse der Meßspule einfallenden magnetischen Feldes dargestellt. Das Feld wird aufgrund des Bündelungeffektes des Ferritkernes 1 in dessen Primärjoch 2 wegen des geringeren magnetischen Widerstandes gegenüber dem Sekundärjoch 4 derart verdichtet, daß der im Sekundärjoch 4 und damit im Luftspalt 5 auftretende magnetische Nebenfluß demgegenüber vernachlässigbar gering ist.

In Fig. 5 ist der Feldlinienverlauf eines auf den Wandler senkrecht zur Spulenachse einwirkenden äußeren Magnetfeldes dargestellt. In diesem Falle verdichten sich die magnetischen Feldlinien in den beiden Schenkeln 7, 8 des Kernes und bleiben auf den Luftspalt 5 und damit die Meßspule 6 ohne Wirkung.

In Fig. 6 ist der Spulenkörper 9 aus nichtmagnetischem Material mit der Meßspule 6 im Querschnitt dargestellt. Die Fig. 7 zeigt den Spulenkörper in einer Draufsicht. Aus beiden Figuren ist zu erkennen, daß der Spulenkörper 9 aus einer rahmenförmigen Halterung mit flexiblen Befestigungslaschen 10 gebildet ist, die so angeordnet und bemessen sind, daß diese den Spulenkörper 6 im eingeführten und justierten Zustand nach Art eines Schnappverschlusses am Sekundärjoch 4 fixieren. Der Luftspalt selbst und damit auch die Höhe des Spulenkörpers sind so bemessen, daß der Einfluß einer eventuellen Gleichstromvormagnetisierung innerhalb der Toleranzgrenzen der Meßgenauigkeit bleibt.

## Patentansprüche

1. Strom-Spannungswandler für elektronische Haushaltszähler, dessen Primärwindung über einen ferromagnetischen Kern mit einer Meßspule magnetisch gekoppelt ist, **dadurch gekennzeichnet**, daß der ferromagnetische Kern (1) bis auf einen Luftspalt (5) geschlossen ist, daß die Meßspule (6) mit der Spulenachse in Feldlinienrichtung in den Luftspalt (5) eingefügt, befestigt und so bemessen ist, daß diese innerhalb der Querschnittsfläche des Kernes liegt.

2. Strom-Spannungswandler nach Anspruch 1, **dadurch gekennzeichnet**, daß als ferromagnetischer Kern ein Ferritkern benutzt ist.

3. Strom-Spannungswandler nach Anspruch 1 oder 2, **dadurch gekennzeichnet**, daß der Kern (1) einen quadratischen Querschnitt und eine rechteckige Form mit einem von der Primärwindung (3) umschlossenen Primärjoch (2) und einem über parallele Schenkel (7, 8) mit diesem verbundenen, vom Luftspalt (5) unterbrochenen Sekundärjoch (4) besitzt.

4. Strom-Spannungswandler nach einem der vorhergehenden Ansprüche, **dadurch gekennzeichnet,** daß die Meßspule (6) auf einem Spulenkörper (9) aus elastischem Kunststoff aufgebracht ist, der mit federnden Befestigungslaschen (10) versehen ist, die den im Luftspalt (5) angeordneten Spulenkörper (9) lösbar am Kern fixieren.

## Claims

1. Current-voltage transformer for electronic domestic electricity meters, the primary winding of which is magnetically coupled to a measuring coil by way of a ferromagnetic core, characterised in that the ferromagnetic core (1) is closed except for an air gap (5), in that the measuring coil (6) is inserted in the air gap (5) and secured therein with the coil axis in the direction of the field lines, and has dimensions such that it is located within the cross-sectional area of the core.

2. Current-voltage transformer according to claim 1, characterised in that a ferrite core is used as the ferromagnetic core.

3. Current-voltage transformer according to claim 1 or 2, characterised in that the core (1) has a square cross section and a rectangular shape having a primary yoke (2) surrounded by the primary winding (3) and a secondary yoke (4) interrupted by the air gap (5) and connected to the primary yoke (2) by way of parallel branches (7, 8).

4. Current-voltage transformer according to one of the preceding claims, characterised in that the measuring coil (6) is placed on a coil former (9) made of flexible plastics material, which coil former (9) is provided with resilient securing tabs (10) which detachably fix the coil former (9) arranged in the air gap (5) to the core.

## Revendications

1. Convertisseur courant-tension pour des compteurs électroniques domestiques, dont l'enroulement primaire est couplé magnétiquement à une bobine de mesure par l'intermédiaire d'un noyau ferromagnétique, caractérisé par le fait que le noyau ferromagnétique (1) est fermé à l'exception d'un entrefer (5), que la bobine de mesure (6) est insérée, en ayant son axe dans la direction des lignes de champ, dans l'entrefer (5) est fixée et à des dimensions telles que la bobine soit à l'intérieur de la surface en coupe transversale du noyau.

2. Convertisseur courant-tension suivant la revendication 1, caractérisé par le fait qu'un noyau de ferrite est utilisé comme noyau ferromagnétique.

3. Convertisseur courant-tension suivant la revendication 1 ou 2, caractérisé par le fait que le noyau (1) possède une section transversale carrée et une forme rectangulaire en ayant une culasse primaire (2) entourée de l'enroulement primaire (3), et une culasse secondaire (4) reliée à cette culasse primaire par des branches (7, 8) parallèles et interrompue par l'entrefer (5).

4. Convertisseur courant-tension suivant l'une des revendications précédentes, caractérisé par le fait que la bobine de mesure (6) est montée sur un corps de bobine (9) en un matériau élastique et muni de pattes (10) élastiques de fixation, qui fixent le corps de bobine (9), placé dans l'entrefer (5), au noyau d'une manière amovible.
